# EUROPÄISCHE PATENTSCHRIFT

(11) **EP 3 630 541 B1**
(45) Veröffentlichungstag und Bekanntmachung des Hinweises auf die Patenterteilung: **07.05.2025**
(21) Anmeldenummer: 18722432.4
(22) Anmeldetag: 26.04.2018
(51) Int. Cl.: B60Q 1/14

(54) **SCHALTER MIT UMLENKHEBEL UND GROSSEM SCHALTWEG**
SWITCH WITH DEFLECTION LEVER AND LARGE SWITCHING PATH
COMMUTATEUR COMPORTANT UN LEVIER DE RENVOI ET UNE GRANDE COURSE DE COMMUTATION

(30) Priorität: 22.05.2017 DE 102017111052
(43) Veröffentlichungstag der Anmeldung: 08.04.2020
(73) Patentinhaber: Valeo Schalter und Sensoren GmbH, 74321 Bietigheim-Bissingen (DE)
(72) Erfinder: STAUDE, Sascha, 74321 Bietigheim-Bissingen (DE); PIKART, Daniela, 74321 Bietigheim-Bissingen (DE)
(74) Vertreter: Pothmann, Karsten
(86) Internationale Anmeldenummer: PCT/EP2018/060651
(87) Internationale Veröffentlichungsnummer: WO 2018/215157

(56) Entgegenhaltungen:
- DE-A1- 102014 011 501
- DE-A1- 4 238 070
- DE-T2- 69 702 600
- JP-A- 2015 176 652
- JP-A- 2015 216 038
- JP-A- 2017 016 920

## Beschreibung

Die vorliegende Erfindung betrifft einen Schalter, insbesondere als Lenkstockschalter zur Anordnung an einem Lenkstock eines Fahrzeuges gemäß der Präambel des Anspruchs 1.

Des Weiteren betrifft die vorliegende Erfindung ein Fahrzeug mit einem obigen Schalter.

Als Lenkstockschalter werden mit einem Schalthebel versehene Schalter bezeichnet, die am Lenkstock eines Fahrzeugs zwischen Armaturenbrett und Lenkrad angebracht sind. Lenkstockschalter können in modernen Fahrzeugen direkt mit einem Steuergerät am Lenkstock verbunden sein, welches verschiedene Zustände am Schalthebel unmittelbar in entsprechende Schaltsignale umwandeln kann. Die Schaltsignale können beispielsweise über einen Fahrzeugbus weiter übertragen werden. Als Bussystems sind beispielsweise CAN, LIN oder Flexray bekannt.

Grundlegende Anwendungen für Lenkstockschalter sind Fahrtrichtungsanzeiger, auch als Blinker bekannt, Fahrzeugbeleuchtung umfassend Abblendlicht, Fernlicht und ggf. Lichthupe, sowie Scheibenwisch- und -Waschsteuerung.

Darüber hinaus sind Lenkstockschalter als Bedienelemente für eine Geschwindigkeitsregelautomatik, auch Tempomat genannt, oder die Fernsteuerung von Autoradios bekannt.

Mit jedem Schalthebel können dabei mehrere Funktionen realisiert werden, die durch tangentiale Bewegung mit Rast- oder Tippfunktion, wie beispielsweise beim Fahrtrichtungsanzeiger, durch Ziehen gegen einen Widerstand für die Lichthupe oder Drücken mit Raste für das Fernlicht ausgelöst werden können.

Prinzipiell sind auch derartige Schalter mit einer Magnetbetätigung bekannt. Dabei ist an dem Schalthebel innenliegend ein Schaltglied angebracht, dass sich von dem Schalthebel radial erstreckt, und an dessen Spitze ein magnetisches Signalisierungselement angebracht ist. Die Position des Signalisierungselements wird von einem Magnetsensor erkannt. Nachteilig an diesen Schaltern ist jedoch, dass eine Unterscheidung verschiedener Schalterstellungen direkt abhängig von der Bewegung des Schaltglieds ist, dessen Bewegung wiederum direkt abhängig von der Bewegung des Schalthebels ist, so dass zur zuverlässigen Unterscheidung der Schalterpositionen eine große Länge der Schaltglieds erforderlich ist, was wiederum einen großen Bauraum erfordert.

In diesem Zusammenhang ist aus der DE 199 22 500 A1 eine Schaltervorrichtung bekannt, insbesondere für Kraftfahrzeuge, bei der eine Betätigung des Betätigungselements berührungslos erfasst wird und die Schaltervorrichtung als Modul ausgebildet ist.

Außerdem ist aus der DE 10 2005 018 289 A1 ein Schalter bekannt, insbesondere Lenkstockschalter zur Anordnung an einen Lenkstock eines Fahrzeuges, mit einem betätigbaren Schalthebel, mit einem mit dem Schalthebel bewegungsgekoppelten Schaltglied, wobei das eine Schaltglied um wenigstens zwei quer zueinander angeordnete Achsen schwenkbar ist und im Bereich seiner Oberfläche verschieden polarisierte Magnetabschnitte aufweist, und mit einer Magnetfeldsensoren aufweisenden Elektronikeinheit, wobei über die Magnetfeldsensoren die jeweilige Schaltlage des einen Schaltglieds erfasst und ein entsprechender Schaltvorgang eingeleitet werden kann und wobei zwischen dem einen Schaltglied und den Magnetfeldsensoren eine Wandung angeordnet ist, die von dem vom Schaltglied ausgehenden Magnetfeld durchdrungen wird.

Weitere Lenkstockschalter sind aus JP 2017 016920 A und JP 2015 176652 A bekannt. Ausgehend von dem oben genannten Stand der Technik liegt der Erfindung somit die Aufgabe zugrunde, einen Schalter der oben genannten Art und ein Fahrzeug mit einem solchen Schalter anzugeben, die eine einfache Unterscheidung verschiedener Schalterstellungen ermöglichen und nur geringen Bauraum erfordern.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Schalter angegeben, insbesondere als Lenkstockschalter zur Anordnung an einem Lenkstock eines Fahrzeuges, mit einem betätigbaren Schalthebel, der entlang seiner Längsachse ein Lagerelement aufweist, mit dem der Schalthebel in einem Lager eines Grundgehäuses beweglich gelagert ist, einem mit dem Schalthebel bewegungsgekoppelten Schaltglied, das mit einem berührungslosen Signalisierungselement ausgeführt ist, wobei der Schalthebel auf einer ersten Seite des Lagerelements betätigbar ist, das Schaltglied auf einer zweiten Seite des Lagerelements angeordnet ist, das Schaltglied als Umlenkhebel mit einem ersten und einem zweiten Hebelarm ausgeführt ist, der Umlenkhebel im Verbindungsbereich des ersten und zweiten Hebelarms in einem Umlenklager drehbar an dem Grundgehäuse gehalten ist, an dem ersten Hebelarm das Signalisierungselement angeordnet ist, und der zweite Hebelarm mit dem Schalthebel gekoppelt ist.

Erfindungsgemäß ist außerdem ein Fahrzeug mit einem obigen Schalter angegeben.

Grundidee der vorliegenden Erfindung ist es also, durch die Ausgestaltung des Schaltglieds als Umlenkhebel die Bewegung des Schalthebels von der Bewegung des Signalisierungselements zu entkoppeln. Dadurch kann er Schalter mit kleinem Bauraum ausgeführt werden, da die Bewegung des Signalisierungselements durch die Ausgestaltung des Umlenkhebels wie gewünscht erfolgen kann.

Der Schalthebel kann als einfacher gerader Hebel ausgeführt sein. Allerdings ist es auch möglich, dass der Schalthebel eine beliebige, abweichende Form aufweisen kann. Auch können Abschnitte des Schalthebels auf der ersten Seite und der zweiten Seite nicht in einer Linie, sondern mit einem Winkelversatz in einer prinzipiell beliebigen Richtung angeordnet sein.

Das Lagerelement ist abhängig von Freiheitsgraden der Bewegung des Schalthebels ausgeführt, beispielsweise zur beweglichen Lagerung um eine oder zwei Achsen des Schalthebels.

Die Kopplung des Schaltglieds mit dem Schalthebel ist derart ausgeführt, dass eine Bewegung des Schalthebels auf seiner zweiten Seite eine Bewegung des Umlenkhebels bewirkt wird, mit der daraus resultierenden Bewegung des Signalisierungselements.

In dem Grundgehäuse kann auch das Lagerelement gehalten sein. Das Grundgehäuse stellt eine Struktur bereit, an der Komponenten des Schalters ortsfest angebracht werden können.

Das Schaltglied kann mit dem ersten und einem zweiten Hebelarm derart ausgeführt sein, dass der erste und der zweite Hebelarm prinzipiell einen beliebigen Winkel zueinander aufweisen können. Vorzugsweise sind der erste und der zweite Hebelarm derart angeordnet, dass sie zwischen sich einen Winkel von etwa 90° einschließen.

Erfindungsgemäß ist der Schalthebel um eine Achse schwenkbar, und der Umlenkhebel setzt die Bewegung des Schalthebels in der einen Achse in eine entsprechende Bewegung des Schaltglieds in einer Achse um. Somit können sowohl das Lagerelement wie auch das Umlenklager einfach ausgestaltet sein, da sie jeweils nur ein einfaches Verschwenken unterstützen müssen.

Erfindungsgemäß ist der Schalthebel um zwei quer zueinander angeordnete Achsen schwenkbar, und der Umlenkhebel setzt die Bewegung des Schalthebels in den zwei Achsen in eine Bewegung des Schaltglieds in zwei Achsen um. Dies ermöglicht die Realisierung mehrerer Schaltfunktionen mit nur einem Schalter. Alternativ kann eine zweidimensionale Schaltfunktion mit dem Schalter realisiert werden.

In vorteilhafter Ausgestaltung der Erfindung weist der zweite Hebelarm eine geringere Länge auf als der erste Hebelarm. Durch die geringere Länge des zweiten Hebelarms kann eine prinzipiell geringere Bewegung des Schalthebels in eine größere Bewegung des Signalisierungselements umgesetzt werden, wodurch der Schaltweg vergrößert werden kann. Dadurch können verschiedene Positionen des Schalthebels mit üblichen Sensoren leicht erkannt werden. Die Länge des jeweiligen Hebelarms betrifft eine effektive Hebellänge, d.h. eine Länge vom Umlenklager zu dem Signalisierungselement bzw. zu einer Position der Kopplung mit dem Schalthebel.

In vorteilhafter Ausgestaltung der Erfindung weist der zweite Hebelarm eine Längsführung auf, mit der der zweite Hebelarm in Richtung der Längsachse des Schalthebels verschiebbar mit diesem gekoppelt ist. Mit der Längsführung wird eine gute Beweglichkeit des Schaltglieds erreicht, was insbesondere für eine Bewegung um mehrere Achsen vorteilhaft ist. Es wird eine bewegliche Kopplung zwischen dem zweiten Hebelarm und dem Schalthebel gebildet.

In vorteilhafter Ausgestaltung der Erfindung sind das Schaltglied und das Lagerelement in Richtung von der Längsachse des Schalthebels axial versetzt an dem Schalthebel angeordnet. Die Anordnung des Schaltglieds an dem Schalthebel ist also von der Lagerung in dem Lagerelement getrennt. Dadurch kann die Bewegung des Schaltglieds und insbesondere des Signalisierungselements frei gestaltet werden. Insbesondere können aufgrund unterschiedlicher Hebellänge des Schalthebels Auslenkungen des Schalthebels durch das Signalisierungselement verstärkt wiedergegeben werden, um eine Auflösung des Schalters zu verbessern oder ein Ansprechen des Schalters exakt definieren zu können. Die Bewegung des Signalisierungselements kann insbesondere durch die Kombination mit dem als Umlenkhebel ausgeführten Schaltglied frei gestaltet werden.

In vorteilhafter Ausgestaltung der Erfindung ist das Schaltglied derart ausgeführt und angeordnet, dass sich der zweite Hebelarm im Wesentlichen in Richtung des Lagerelements erstreckt, und zwischen dem Lagerelement und dem Umlenklager mit dem Schalthebel gekoppelt ist. Dadurch kann bereits eine kleine absolute Bewegung des Schalthebels in eine korrespondierende, große Bewegung des Signalisierungselements umgesetzt werden. Der Schalthebel kann mit einer geringen Erstreckung in Längsrichtung ausgeführt sein, wodurch der Schalter insgesamt eine geringe Baugröße aufweisen kann. In einer alternativen Ausführungsform kann das Schaltglied derart ausgeführt und angeordnet, dass sich der zweite Hebelarm im Wesentlichen in Richtung von dem Lagerelement weg erstreckt. Entsprechend ist der zweite Hebelarm ausgehend von dem Umlenklager auf der dem Lagerelement entgegengesetzten Seite des Schalthebels mit diesem gekoppelt.

In vorteilhafter Ausgestaltung der Erfindung ist das Signalisierungselement ein magnetisches Signalisierungselement, und der Schalter weist einen Magnetsensor auf, um die Bewegung des Signalisierungselements zu erfassen. Der Magnetsensor ist in Übereinstimmung mit der Bewegbarkeit des Signalisierungselements ausgeführt. Der Magnetsensor ist vorzugsweise an dem Gehäuse gelagert.

In vorteilhafter Ausgestaltung der Erfindung ist der Magnetsensor ein 3D-Magnetsensor oder ein Magnetsensorfeld. Dies ist vorteilhaft, um eine Bewegung des Schalthebels um mehr als eine Achse zuverlässig durch die korrespondierende Bewegung des Signalisierungselements erfassen zu können.

Nachfolgend wird die Erfindung unter Bezugnahme auf die anliegende Zeichnung anhand bevorzugter Ausführungsbeispiele exemplarisch erläutert, wobei die nachfolgend dargestellten Merkmale sowohl jeweils einzeln als auch in Kombination einen Aspekt der Erfindung darstellen können.

Es zeigt
- Fig. 1: eine Seitenansicht eines Schalters, der als Lenkstockschalter ausgeführt ist, mit einem Schalthebel, einem Gehäuse, einem Schaltglied mit einem berührungslosen Signalisierungselement und einem auf einer Platine angeordneten Magnetsensor gemäß einer ersten, bevorzugten Ausführungsform,
- Fig. 2: eine Draufsicht auf den Schalter aus Fig. 1 in teilweise transparenter Darstellung,
- Fig. 3: die Seitenansicht aus Fig. 1 in teilweise transparenter Darstellung mit vollständig sichtbarem Schaltglied und dessen Kopplung an den Schalthebel, und
- Fig. 4: eine Seitenansicht eines Schalters gemäß einer zweiten Ausführungsform in teilweise transparenter Darstellung mit vollständig sichtbarem Schaltglied und dessen Kopplung an den Schalthebel, wobei das Schaltglied in axialer Richtung des Schalthebels gedreht angeordnet ist.

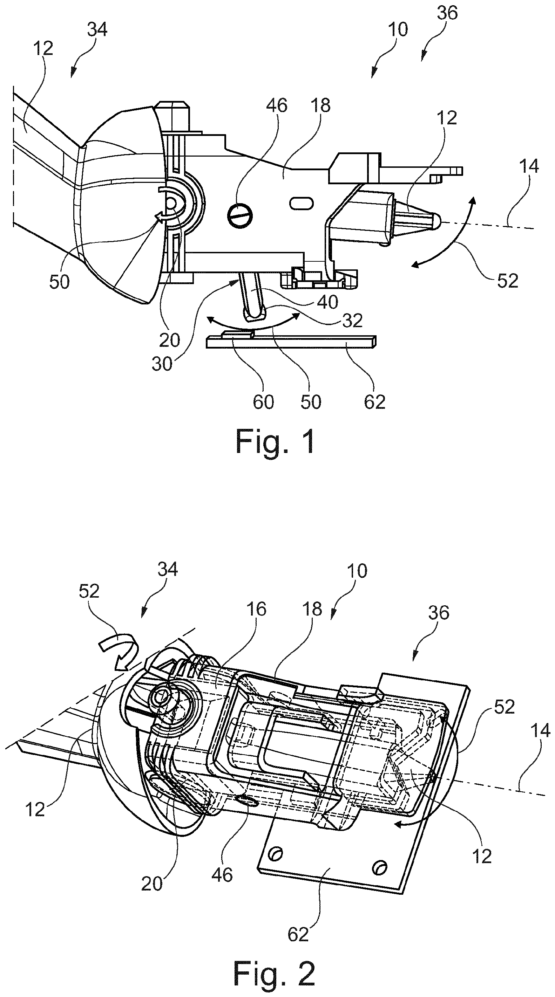

Die Figuren 1 bis 3 zeigen einen als Lenkstockschalter ausgeführten Schalter 10 gemäß einer ersten, bevorzugten Ausführungsform der Erfindung. Der Schalter 10 ist entsprechend zur Anordnung an einem nicht gezeigten Lenkstock eines ebenfalls nicht dargestellten Fahrzeuges ausgeführt.

Der Schalter 10 umfasst einen betätigbaren Schalthebel 12, der entlang seiner Längsachse 14 ein Lagerelement 16 aufweist, mit dem der Schalthebel 12 in einem Lager eines Grundgehäuses 18 beweglich gelagert ist. Das Lagerelement 16 ist in dem Grundgehäuse 18 gehalten.

Der Schalthebel 12 ist auf seiner ersten und zweiten Seite 34, 36 mit einem Winkelversatz ausgeführt ist. Die erste Seite 34 betrifft von dem Lagerelement 16 aus gesehen die Seite des Schalthebels 12, auf welcher der Schalthebel 12 betätigbar ist. Die zweite Seite 36 betrifft die entsprechend andere Seite des Schalthebels 12. Der Schalthebel 12 ist um zwei quer zueinander angeordnete Achsen 50, 52 schwenkbar. Entsprechend ist das Lagerelement 16 in Übereinstimmung mit den Freiheitsgraden der Bewegung des Schalthebels 12 zur beweglichen Lagerung des Schalthebels 12 um die zwei Achsen 50, 52 ausgeführt.

Zusätzlich umfasst der Schalter 10 ein Schaltglied 30, das als Umlenkhebel mit einem ersten und einem zweiten Hebelarm 40, 42 ausgeführt ist. Das Schaltglied 30 ist auf der zweiten Seite 36 des Schalthebels 12 angeordnet. Das Schaltglied 30 ist in Richtung von der Längsachse 14 des Schalthebels 12 axial versetzt zu dem Lagerelement 16 an dem Schalthebel 12 angeordnet, wodurch die Anordnung des Schaltglieds 30 an dem Schalthebel 12 von der Lagerung in dem Lagerelement 16 getrennt ist. In einem besonders vorteilhaften Ausführungs-beispiel sind das Umlenklager (46) des Schaltglieds (30) und das Lager (20) des Lagerelements (16) in Richtung von der Längsachse (14) des Schalthebels (12) axial versetzt zueinander an dem Schalthebel (12) angeordnet.

Das Schaltglied 30 ist derart ausgeführt, dass der erste und der zweite Hebelarm 40, 42 zwischen sich einen Winkel von etwa 90° einschließen. An einer Spitze des ersten Hebelarms 40 ist ein berührungsloses Signalisierungselement 32 angeordnet, und der zweite Hebelarm 42 ist mit dem Schalthebel 12 bewegungsgekoppelt. Die Kopplung des Schaltglieds 30 mit dem Schalthebel 12 ist derart ausgeführt, dass eine Bewegung des Schalthebels 12 auf seiner zweiten Seite 36 eine Bewegung des Schaltglieds 30 bewirkt, mit einer daraus resultierenden Bewegung des Signalisierungselements 32.

Das Schaltglied 30 ist im Verbindungsbereich 44 des ersten und zweiten Hebelarms 40, 42 in einem Umlenklager 46 drehbar an dem Grundgehäuse 18 gehalten. Das Schaltglied 30 setzt die Bewegung des Schalthebels 12 in den zwei Achsen 50, 52 in eine Bewegung des Signalisierungselements 32 in zwei Achsen 50, 52 um.

Das Signalisierungselement 32 ist ein magnetisches Signalisierungselement. Entsprechend umfasst der Schalter 10 einen Magnetsensor 60, um die Bewegung des Signalisierungselements 32 zu erfassen. Der Magnetsensor 60 ist als 3D-Magnetsensor oder Magnetsensorfeld ausgeführt und an dem Grundgehäuse 18 gelagert.

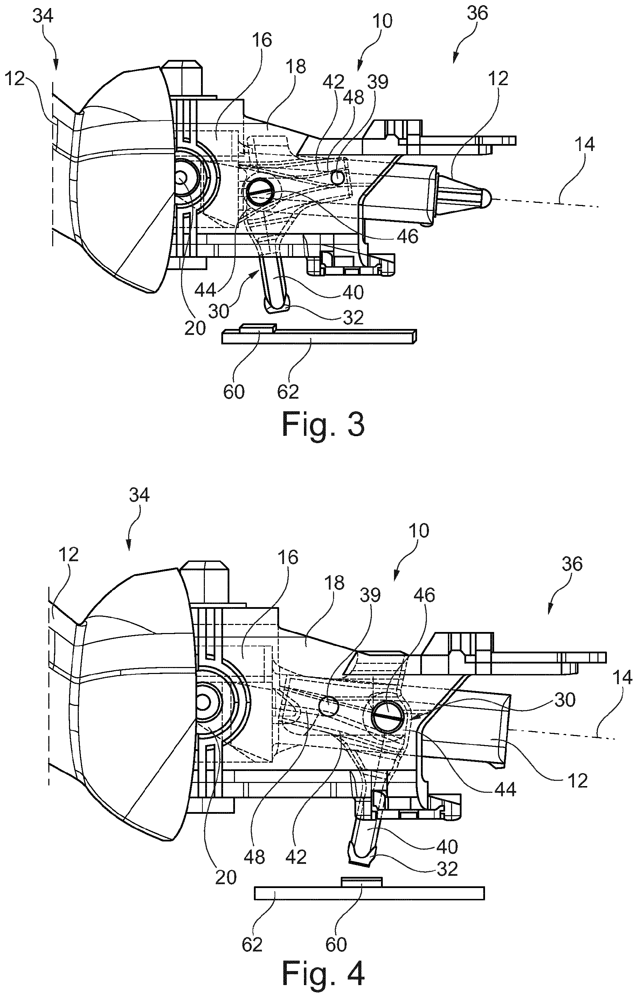

Wie sich aus Fig. 3 ergibt, weist der zweite Hebelarm 42 eine Längsführung 48 auf, mit der der zweite Hebelarm 42 in Richtung der Längsachse 14 des Schalthebels 12 verschiebbar mit diesem gekoppelt ist. Ein Koppelelement 39 ist an der zweiten Seite 36 des Schalthebels 12 ausgebildet, das in der Längsführung 48 geführt ist, um den zweiten Hebelarm 42 über die Längsführung 48 und das Koppelelement 39 mit der zweiten Seite 36 des Schalthebels 12 zu koppeln.

Das Schaltglied 30 ist derart ausgeführt und angeordnet, dass sich dessen zweiter Hebelarm 42 im Wesentlichen in Richtung des Lagerelements 16 erstreckt. Das Schaltglied 30 ist entsprechend an dem zweiten Hebelarm 42 zwischen dem Lagerelement 16 und dem Umlenklager 46 mit dem Schalthebel 12 gekoppelt.

Fig. 4 zeigt einen Schalter 10 gemäß einer zweiten Ausführungsform der Erfindung. Der Schalter 10 der zweiten Ausführungsform ist im Wesentlichen identisch mit dem Schalter 10 der ersten Ausführungsform. Entsprechend werden nur Unterschiede des Schalters 10 der zweiten Ausführungsform gegenüber dem Schalter 10 der ersten Ausführungsform im Detail beschrieben. Nicht beschriebene Details können wie unter Bezug auf die erste Ausführungsform beschrieben ausgeführt sein.

Gemäß der zweiten Ausführungsform ist das Schaltglied 30 derart ausgeführt und angeordnet, dass sich dessen zweiter Hebelarm 42 im Wesentlichen in Richtung von dem Lagerelement 16 weg erstreckt. Das Schaltglied 30 ist entsprechend an dem zweiten Hebelarm 42 von dem Umlenklager 46 aus gesehen auf der dem Lagerelement 16 gegenüberliegenden Seite des Schalthebels 12 mit diesem gekoppelt.

### Bezugszeichenliste

| | |
|---|---|
| Schalter | 10 |
| Schalthebel | 12 |
| Längsachse | 14 |
| Lagerelement | 16 |
| Grundgehäuse | 18 |
| Lager | 20 |
| Schaltglied, Umlenkhebel | 30 |
| Signalisierungselement | 32 |
| erste Seite | 34 |
| zweite Seite | 36 |
| Koppelelement | 39 |
| erster Hebelarm | 40 |
| zweiter Hebelarm | 42 |
| Verbindungsbereich | 44 |
| Umlenklager | 46 |
| Längsführung | 48 |
| erste Achse | 50 |
| zweite Achse | 52 |
| Magnetsensor | 60 |
| Platine | 62 |

## Patentansprüche

1. Schalter (10) für ein Fahrzeug, insbesondere als Lenkstockschalter zur Anordnung an einem Lenkstock eines Fahrzeuges, mit
einem betätigbaren Schalthebel (12), der entlang seiner Längsachse (14) ein Lagerelement (16) aufweist, mit dem der Schalthebel (12) in einem Lager (20) eines Grundgehäuses (18) beweglich gelagert ist,
einem mit dem Schalthebel (12) bewegungsgekoppelten Schaltglied (30), das mit einem berührungslosen Signalisierungselement (32) ausgeführt ist, wobei der Schalthebel (12) auf einer ersten Seite (34) des Lagerelements (16) betätigbar ist, und das Schaltglied (30) auf einer zweiten Seite (36) des Lagerelements (16) angeordnet ist,
wobei das Schaltglied (30) als Umlenkhebel mit einem ersten und einem zweiten Hebelarm (40, 42) ausgeführt ist, der Umlenkhebel (30) im Verbindungsbereich (44) des ersten und zweiten Hebelarms (40, 42) in einem Umlenklager (46) drehbar an dem Grundgehäuse (18) gehalten ist, an dem ersten Hebelarm (40) das Signalisierungselement (32) angeordnet ist, und der zweite Hebelarm (42) mit dem Schalthebel (12) gekoppelt ist, und wobei der Schalthebel (12) um eine Achse (50) schwenkbar ist, und
der Umlenkhebel die Bewegung des Schalthebels (12) um die eine Achse (50) in eine entsprechende Bewegung des Signalisierungselements (32) um die eine Achse (50) umsetzt,
**dadurch gekennzeichnet, dass**
der Schalthebel (12) um eine quer zur Achse (50) angeordnete zweite Achse (52) schwenkbar ist, und
der Umlenkhebel die Bewegung des Schalthebels (12) um die zwei Achsen (50, 52) in eine entsprechende Bewegung des Signalisierungselements (32) um die zwei Achsen (50, 52) umsetzt.

2. Schalter (10) nach einem der vorhergehenden Ansprüche, **dadurch gekennzeichnet, dass**
der zweite Hebelarm (42) eine geringere Länge aufweist als der erste Hebelarm (40).

3. Schalter (10) nach einem der vorhergehenden Ansprüche, **dadurch gekennzeichnet, dass**
der zweite Hebelarm (42) eine Längsführung (48) aufweist, mit der der zweite Hebelarm (42) in Richtung der Längsachse (14) des Schalthebels (12) verschiebbar mit diesem gekoppelt ist.

4. Schalter (10) nach einem der vorhergehenden Ansprüche, **dadurch gekennzeichnet, dass**
das Schaltglied (30) und das Lagerelement (16) in Richtung von der Längsachse (14) des Schalthebels (12) axial versetzt an dem Schalthebel (12) angeordnet sind.

5. Schalter (10) nach Anspruch 4, **dadurch gekennzeichnet, dass**
das Umlenklager (46) des Schaltglieds (30) und das Lager (20) des Lagerelements (16) in Richtung von der Längsachse (14) des Schalthebels (12) axial versetzt zueinander an dem Schalthebel (12) angeordnet sind.

6. Schalter (10) nach einem der vorhergehenden Ansprüche, **dadurch gekennzeichnet, dass**
das Schaltglied (30) derart ausgeführt und angeordnet ist, dass sich der zweite Hebelarm (42) im Wesentlichen in Richtung des Lagerelements (16) erstreckt, und zwischen dem Lagerelement (16) und dem Umlenklager (46) mit dem Schalthebel (12) gekoppelt ist.

7. Schalter (10) nach einem der vorhergehenden Ansprüche, **dadurch gekennzeichnet, dass**
das Signalisierungselement (32) ein magnetisches Signalisierungselement (32) ist, und
der Schalter (10) einen Magnetsensor (60) aufweist, um die Bewegung des Signalisierungselements (32) zu erfassen.

8. Schalter (10) nach einem der vorhergehenden Ansprüche, **dadurch gekennzeichnet, dass**
der Magnetsensor (60) ein 3D-Magnetsensor oder ein Magnetsensorfeld ist.

9. Fahrzeug mit einem Schalter (10) nach einem der vorhergehenden Ansprüche.

## Claims

1. Switch (10) for a vehicle, in particular as a steering column switch for arrangement on a steering column of a vehicle, with
an actuable switch lever (12) which has along its longitudinal axis (14) a bearing element (16) with which the switch lever (12) is mounted movably in a bearing (20) of a base housing (18),
a switching element (30) which is movement-coupled to the switch lever (12) and which is embodied with a contactfree signalling element (32), wherein
the switch lever (12) can be actuated on a first side (34) of the bearing element (16), and the switching element (30) is arranged on a second side (36) of the bearing element (16),
wherein the switching element (30) is embodied as a reversing lever with a first and a second lever arm (40, 42), the reversing lever (30) is retained in the connection region (44) of the first and second lever arm (40, 42) in a reversing bearing (46) rotatably on the base housing (18), the signalling element (32) is arranged on the first lever arm (40), and the second lever arm (42) is coupled to the switch lever (12), and wherein the switch lever (12) is pivotable about an axis (50), and
the reversing lever converts the movement of the switch lever (12) about the one axis (50) into a corresponding movement of the signalling element (32) about the one axis (50),
**characterized in that**
the switch lever (12) is pivotable about a second axis (52) arranged transversely to the axis (50), and
the reversing lever converts the movement of the switch lever (12) about the two axes (50, 52) into a corresponding movement of the signalling element (32) about the two axes (50, 52).

2. Switch (10) according to any of the preceding claims, **characterized in that**
the second lever arm (42) has a smaller length than the first lever arm (40).

3. Switch (10) according to any of the preceding claims, **characterized in that**
the second lever arm (42) has a longitudinal guide (48) with which the second lever arm (42) is coupled to the switch lever (12) displaceably in the direction of the longitudinal axis (14) of the switch lever (12).

4. Switch (10) according to any of the preceding claims, **characterized in that**
the switching element (30) and the bearing element (16) are arranged on the switch lever (12) axially offset in the direction of the longitudinal axis (14) of the switch lever (12).

5. Switch (10) according to Claim 4, **characterized in that**
the reversing bearing (46) of the switching element (30) and the bearing (20) of the bearing element (16) are arranged on the switch lever (12) axially offset to one another in the direction of the longitudinal axis (14) of the switch lever (12).

6. Switch (10) according to any of the preceding claims, **characterized in that**
the switching element (30) is embodied and arranged in such a manner that the second lever arm (42) extends substantially in the direction of the bearing element (16) and is coupled to the switch lever (12) between the bearing element (16) and the reversing bearing (46).

7. Switch (10) according to any of the preceding claims, **characterized in that**
the signalling element (32) is a magnetic signalling element (32), and
the switch (10) has a magnetic sensor (60) in order to detect the movement of the signalling element (32).

8. Switch (10) according to any of the preceding claims, **characterized in that**
the magnetic sensor (60) is a 3D magnetic sensor or a magnetic sensor field.

9. Vehicle with a switch (10) according to any of the preceding claims.

## Revendications

1. Commutateur (10) destiné à un véhicule, en particulier sous forme de commutateur de colonne de direction, à disposer sur une colonne de direction d'un véhicule, comprenant
un levier de commutation actionnable (12) qui présente le long de son axe longitudinal (14) un élément de palier (16) par lequel le levier de commutation (12) est monté mobile dans un palier (20) d'un boîtier de base (18),
un organe de commutation (30) couplé en mouvement au levier de commutation (12) qui est réalisé avec un élément de signalisation sans contact (32), dans lequel le levier de commutation (12) peut être actionné sur un premier côté (34) de l'élément de palier (16), et l'organe de commutation (30) est disposé sur un deuxième côté (36) de l'élément de palier (16),
dans lequel l'organe de commutation (30) est réalisé sous forme de levier de renvoi pourvu d'un premier et d'un deuxième bras de levier (40, 42), le levier de renvoi (30) est maintenu rotatif sur le boîtier de base (18) dans la zone de liaison (44) du premier et du deuxième bras de levier (40, 42) dans un palier de renvoi (46), l'élément de signalisation (32) est disposé sur le premier bras de levier (40), et le deuxième bras de levier (42) est couplé au levier de commutation (12), et dans lequel le levier de commutation (12) peut pivoter autour d'un axe (50), et
le levier de renvoi convertit le mouvement du levier de commutation (12) autour d'un axe (50) en un mouvement correspondant de l'élément de signalisation (32) autour dudit axe (50),
**caractérisé en ce que**
le levier de commutation (12) peut pivoter autour d'un deuxième axe (52) disposé transversalement à l'axe (50), et
le levier de renvoi convertit le mouvement du levier de commutation (12) autour des deux axes (50, 52) en un mouvement correspondant de l'élément de signalisation (32) autour des deux axes (50, 52).

2. Commutateur (10) selon l'une quelconque des revendications précédentes, **caractérisé en ce que**
le deuxième bras de levier (42) présente une longueur inférieure au premier bras de levier (40).

3. Commutateur (10) selon l'une quelconque des revendications précédentes, **caractérisé en ce que**
le deuxième bras de levier (42) présente un guidage longitudinal (48) avec lequel le deuxième bras de levier (42) est couplé à celui-ci de manière mobile en direction de l'axe longitudinal (14) du levier de commutation (12).

4. Commutateur (10) selon l'une quelconque des revendications précédentes, **caractérisé en ce que**
l'organe de commutation (30) et l'élément de palier (16) sont disposés sur le levier de commutation (12) de manière axialement décalée en direction de l'axe longitudinal (14) du levier de commutation (12).

5. Commutateur (10) selon la revendication 4, **caractérisé en ce que**
le palier de renvoi (46) de l'organe de commutation (30) et le palier (20) de l'élément de palier (16) sont disposés sur le levier de commutation (12) en direction de l'axe longitudinal (14) du levier de commutation (12) de manière axialement décalée l'un par rapport à l'autre.

6. Commutateur (10) selon l'une quelconque des revendications précédentes, **caractérisé en ce que**
l'organe de commutation (30) est réalisé et disposé de telle sorte que le deuxième bras de levier (42) s'étend substantiellement en direction de l'élément de palier (16), et est couplé au levier de commutation (12) entre l'élément de palier (16) et le palier de renvoi (46).

7. Commutateur (10) selon l'une quelconque des revendications précédentes, **caractérisé en ce que**
l'élément de signalisation (32) est un élément de signalisation magnétique (32), et
le commutateur (10) présente un capteur magnétique (60) pour détecter le mouvement de l'élément de signalisation (32).

8. Commutateur (10) selon l'une quelconque des revendications précédentes, **caractérisé en ce que**
le capteur magnétique (60) est un capteur magnétique 3D ou un champ de capteur magnétique.

9. Véhicule comprenant un commutateur (10) selon l'une quelconque des revendications précédentes.
